# EUROPEAN PATENT SPECIFICATION

(11) **EP 3 382 565 B1**
(45) Date of publication and mention of the grant of the patent: **23.10.2019**
(21) Application number: 18161628.5
(22) Date of filing: 13.03.2018
(51) Int. Cl.: G06F 13/16, G06F 1/32, G06N 3/063

(54) **SELECTIVE NOISE TOLERANCE MODES OF OPERATION IN A MEMORY**
BETRIEBSARTEN MIT SELEKTIVER RAUSCHTOLERANZ IN EINEM SPEICHER
MODES DE FONCTIONNEMENT DE TOLÉRANCE DE BRUIT SÉLECTIVE DANS UNE MÉMOIRE

(30) Priority: 30.03.2017 US 201715475029
(43) Date of publication of application: 03.10.2018
(73) Proprietor: INTEL Corporation, Santa Clara, CA 95054 (US)
(72) Inventor: KURIAN, Dileep J., 560093 Bangalore (IN); V, Ambili, 560103 Bangalore (IN); DIVAKAR, Dilin, 560076 Bangalore (IN)
(74) Representative: Rummler, Felix

(56) References cited:
- EP-A1- 2 385 468
- JP-A- 2002 132 700
- US-A1- 2014 046 885
- US-A1- 2015 213 845
- US-A1- 2016 328 647

## Description

### TECHNICAL FIELD

Certain embodiments of the present description relate generally to management of memory resources.

### BACKGROUND

A non-volatile memory capable of storing a large amount of data frequently has drawbacks such as slower input/output speeds as compared to volatile, smaller capacity memories. Conversely, smaller, volatile memories which may be faster to operate, may have a greater cost to store data on a per bit basis, as compared to larger capacity non-volatile memories. However, data stored in a volatile memory may be lost in the event of a loss of power or a system reset. Accordingly, power is typically supplied continuously to a volatile memory as long as the data stored in the volatile memory is to be maintained.

One type of volatile memory is a dynamic random access memory (DRAM) in which data stored in the memory is typically "refreshed" in cyclical refresh operations. Another type of volatile memory is a static random access memory (SRAM) which can maintain data without refresh operations but nonetheless typically requires a continuing supply of power to maintain the data stored in the SRAM memory. As such, power consumption by volatile memories is frequently a concern, not only in mobile applications having a limited power supply, but also in stationary systems in which the memory consumes a substantial amount of power.

US2015/213845A1 relates to a system including a memory device, a controller, and a power supply. The controller stores a write data in the memory device, and generates a voltage control signal by comparing a read data outputted from the memory device with the write data. The power supply controls a level of a power supply voltage supplied to the memory device in response to the voltage control signal.

### SUMMARY OF THE INVENTION

The invention is defined in the claims. In the following description, any embodiment referred to and not falling within the scope of the claims is merely an example useful to the understanding of the invention.

### BRIEF DESCRIPTION OF THE DRAWINGS

Embodiments of the present disclosure are illustrated by way of example, and not by way of limitation, in the figures of the accompanying drawings in which like reference numerals refer to similar elements.
FIG. 1 depicts a high-level block diagram illustrating one embodiment of a system employing selective noise tolerance modes of memory operation in accordance with the present description.
FIGs. 2a-2b and 3a-3b depict various hierarchical levels of data storage of the memory of FIG. 2.
FIG. 4 depicts an embodiment of a memory interface employing selective noise tolerance modes of memory operation in accordance with the present description.
FIG. 5 is a data structure depicting an example of selective noise tolerance modes of memory operation and associated memory input power levels in accordance with the present description.
FIG. 6 depicts an embodiment of a data transfer logic employing selective noise tolerance modes for memory operation in accordance with the present description.
FIG. 7 is a data structure depicting an example of selective noise tolerance modes of memory operation associated with various workload processing layers in accordance with the present description.
FIG. 8 depicts an embodiment of a memory employing selective noise tolerance modes of memory operation having associated memory input power levels in accordance with the present description.
FIG. 9 depicts an example of dynamically changing memory input power levels in association with dynamically changing selective noise tolerance modes of memory operation, in accordance with the present description.
FIG. 10 depicts an embodiment of a memory employing multiple memory banks having selective noise tolerance modes of memory operation with associated memory input power levels in accordance with the present description.
FIG. 11 depicts another embodiment of a memory employing multiple memory banks having selective noise tolerance modes of memory operation with associated memory input power levels in accordance with the present description.
FIG. 12 depicts a word of workload processing data having portions stored in different memory banks of the embodiment of FIG. 11.
FIG. 13 is a data structure depicting another example of selective noise tolerance modes of memory operation associated with various memory banks for various workload processing layers in accordance with the present description.
FIG. 14 depicts one embodiment of operations of a system employing selective noise tolerance modes of memory operation in accordance with the present description.

### DESCRIPTION OF EMBODIMENTS

In the description that follows, like components have been given the same reference numerals, regardless of whether they are shown in different embodiments. To illustrate one or more embodiments of the present disclosure in a clear and concise manner, the drawings may not necessarily be to scale and certain features may be shown in somewhat schematic form. Features that are described or illustrated with respect to one embodiment may be used in the same way or in a similar way in one or more other embodiments or in combination with or instead of features of other embodiments.

A system employing selective noise tolerance modes of memory operation in accordance with one aspect of the present description can reduce levels of memory operation power consumption as compared to those achieved by many prior devices. In one embodiment, each noise tolerance mode has an associated level of input power to a memory. For example, in one embodiment, the greater the degree of tolerance for noise in the data of a workload being processed, the greater the reduction in memory input power and the greater the resultant reduction in power consumption.

A system employing selective noise tolerance modes of memory operation in accordance with the present description may be utilized in connection with a variety of different processing workloads having various levels of tolerance for noise in the data being processed. For example, deep learning based algorithms and neural networks are commonly used in several machine learning application areas including feature map recognition, audio/video recognition, video summarization etc. These workloads currently run on a variety of hardware platforms ranging from central processing units (CPUs) to graphic processing units (GPUs), for example.

To reduce power consumption and increase performance, performance per watt expended is increasingly becoming a significant differentiator in machine learning application areas. For example, a variety of custom hardware accelerators have been proposed to achieve reductions in power consumption, increase performance or both. Other approaches have been directed to various compression techniques for compressing the data being processed by the processing workloads.

It is recognized that some algorithms employed in machine learning can tolerate a degree of "noise" in the data being processed. As used herein, the term "noise" refers to errors in the data being processed. The errors may occur in the data as originally obtained. For example, improperly calibrated sensors or defects in the sensors themselves may introduce errors in the original data being gathered prior to processing by the algorithm.

One approach which takes advantage of noise tolerance utilizes quantization of data to reduce the number of bits representing a particular data point. For example, a data point representing a pixel of data or a segment of an audio waveform may be reduced in size from a word of data having a relatively large number of bits to a smaller word having eight bits, for example, to improve performance or reduce power consumption or both.

It is appreciated herein that deep learning based algorithms and other algorithms having multiple layers of processing often exhibit varying levels of noise immunity or noise tolerance from one processing layer to another processing layer. For example, the initial processing layers often tend to be more tolerant of noise in the data being processed, as compared to upper or subsequent processing layers, for example, which tend to be more abstract or complex. Accordingly, the more abstract or complex a processing layer, the less tolerant to noise in the data being processed the layer tends to be. Accordingly, a deep learning based algorithm which utilizes quantization of data may have various quantization modes and formats of data, such that initial layers having a higher tolerance for noise in the data may have increased quantization of data, thereby reducing the size of the data to a greater degree than that employed for subsequent layers having a lesser degree of noise tolerance. Thus, variable precision of data may be employed for different processing layers of the algorithm. It is appreciated that such variable precision may impose significant burdens due to increased complexity of hardware, software or both.

In one aspect of the present description, it is appreciated herein that noise or errors in the data may also be introduced by the storage of the data for algorithms having multiple layers of processing. For example, bit errors in the data may be caused by improperly functioning bitcells. To reduce or eliminate such bit errors, a minimum input voltage to the memory may be specified by the manufacturer of the memory in an attempt to ensure proper operation of as many bitcells of the memory as possible.

One aspect of selective noise tolerance modes of memory operation in accordance with the present description includes controlling a multi-level power supply for a memory in a selectable memory input power mode as a function of a selected noise tolerance mode of memory operation. Accordingly, a memory input power mode may be selected from a plurality of memory input power modes as a function of the noise tolerance level of a workload processing layer being executed.

Various embodiments are described herein in terms of selecting levels of input power to a memory. It is appreciated that input power may be selected using a variety of different electrical parameters which when varied, in turn affects the level of power consumption of the memory. For example, selecting a level of input voltage to a memory is considered herein to select a level of input power as that term is used herein since the level of input voltage affects the power consumption of the memory. As another example, selecting a level of input current to a memory is considered herein to select a level of input power as that term is used herein since the level of input current affects the power consumption of the memory. It is appreciated that levels of input power may be selected using a variety of different techniques depending upon the particular application.

In another aspect of the present description, various parameters of selective noise tolerance modes of memory operation in accordance with the present description may be programmable. For example, particular memory input power levels may be programmed by setting registers or other data structures to store values representing one or more programmable input power levels. As another example, noise tolerance levels and memory input power levels associated with various workload processing layers may be programmed in a similar manner.

The various parameters of selective noise tolerance modes of memory operation in accordance with the present description may programmed at the time of manufacture of the memory controller or other device employing selective noise tolerance modes of memory operation. Also, in some embodiments, system users and applications running on the system may be provided a capability of programming one or more parameters of selective noise tolerance modes of memory operation in accordance with the present description such as those described above, for example, in real time while the system is in use.

Selective noise tolerance modes of memory operation in accordance with the present description may be employed alone or in combination with other techniques such as the quantization of data having various quantization modes and formats of data, for example. Thus, initial layers having a higher tolerance for noise in the data may have a selected noise tolerance mode of operation in combination with increased quantization of data to improve performance, reduce power consumption, or both.

Implementations of the described techniques may include hardware, a method or process, or computer software on a computer-accessible medium. Thus, embodiments include corresponding computer systems, apparatus, and computer programs recorded on one or more computer storage devices, each configured to perform the actions of the methods.

A memory interface employing selective noise tolerance modes of memory operation in accordance with the present description is described herein in connection with sectors of data, blocks of sectors, regions of blocks and banks of regions. However, it is appreciated that a memory interface in accordance with the present description may be applied to other units and subunits of data such as volumes, tracks, segments, files, bytes, etc.

A memory interface having selective noise tolerance modes of memory operation in accordance with the present description may, in one embodiment, be employed in a system of one or more computers configured to perform particular operations or actions of selective noise tolerance modes of memory operation, by virtue of having software, firmware, hardware, or a combination of them installed on the system that in operation causes or cause the system to perform the actions. One or more computer programs can be configured to perform particular operations or actions of selective memory input power mode authorization enforcement, by virtue of including instructions that, when executed by data processing apparatus, cause the apparatus to perform the actions.

Other embodiments include corresponding computer systems, apparatus, and computer programs recorded on one or more computer storage devices, each configured to perform the actions of the methods. Implementations of the described techniques may include hardware, a method or process, or computer software on a computer-accessible medium.

Thus, the operations described herein are performed by logic which is configured to perform the operations either automatically or substantially automatically with little or no system operator intervention, except where indicated as being performed manually such as user selection. Thus, as used herein, the term "automatic" includes both fully automatic, that is operations performed by one or more hardware or software controlled machines with no human intervention such as user inputs to a graphical user selection interface. As used herein, the term "automatic" further includes predominantly automatic, that is, most of the operations (such as greater than 50%, for example) are performed by one or more hardware or software controlled machines with no human intervention such as user inputs to a graphical user selection interface, and the remainder of the operations (less than 50%, for example) are performed manually, that is, the manual operations are performed by one or more hardware or software controlled machines with human intervention such as user inputs to a graphical user selection interface to direct the performance of the operations.

Many of the functional elements described in this specification have been labeled as "logic," in order to more particularly emphasize their implementation independence. For example, a logic element may be implemented as a hardware circuit comprising custom Very Large Scale Integrated (VLSI) circuits or gate arrays, off-the-shelf semiconductors such as logic chips, transistors, or other discrete components. A logic element may also be implemented in programmable hardware devices such as field programmable gate arrays, programmable array logic, programmable logic devices or the like.

A logic element may also be implemented in software for execution by various types of processors. A logic element which includes executable code may, for instance, comprise one or more physical or logical blocks of computer instructions which may, for instance, be organized as an object, procedure, or function. Nevertheless, the executables of an identified logic element need not be physically located together, but may comprise disparate instructions stored in different locations which, when joined logically together, comprise the logic element and achieve the stated purpose for the logic element.

Indeed, executable code for a logic element may be a single instruction, or many instructions, and may even be distributed over several different code segments, among different programs, among different processors, and across several memory devices. Similarly, operational data may be identified and illustrated herein within logic elements, and may be embodied in any suitable form and organized within any suitable type of data structure. The operational data may be collected as a single data set, or may be distributed over different locations including over different storage devices.

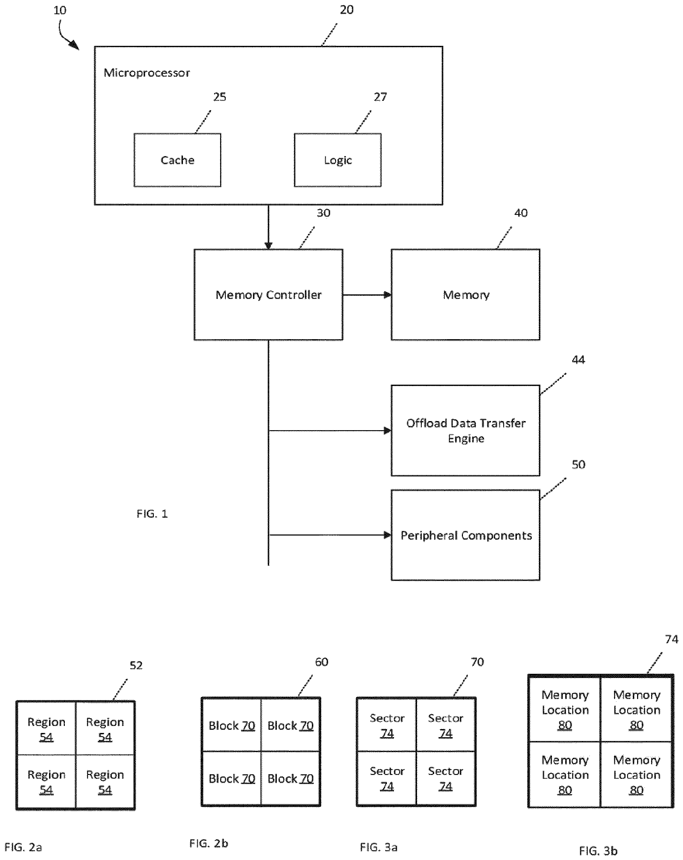

FIG. 1 is a high-level block diagram illustrating selected aspects of a computing system implemented according to an embodiment of the present disclosure. System 10 may represent any of a number of electronic or other computing devices, that may include a memory device. Such electronic devices may include a cloud storage system and other computing devices such as a mainframe, server, personal computer, workstation, telephony device, network appliance, virtualization device, storage controller, portable or mobile devices (e.g., laptops, netbooks, tablet computers, personal digital assistant (PDAs), portable media players, portable gaming devices, digital cameras, mobile phones, smartphones, feature phones, etc.) or component (e.g. system on a chip, processor, bridge, memory controller, memory, etc.). System 10 can be powered by a battery, renewable power source (e.g., solar panel), wireless charging, or by use of an AC outlet.

In alternative embodiments, system 10 may include more elements, fewer elements, and/or different elements. Moreover, although system 10 may be depicted as comprising separate elements, it will be appreciated that such elements may be integrated on to one platform, such as systems on a chip (SoCs). In the illustrative example, system 10 comprises a central processing unit or microprocessor 20, a memory controller 30, a memory 40, an offload data transfer engine 44, and peripheral components 50 which may include, for example, video controller, input device, output device, storage, network adapter or interface, a power source (including a battery, renewable power source (e.g., photovoltaic panel), wireless charging, or coupling to an AC outlet), etc..

The microprocessor 20 includes a cache 25 that may be part of a memory hierarchy to store instructions and data, and the memory 40 may also be part of the memory hierarchy. The microprocessor 20 further includes logic 27 which may include one or more cores, and may include a system agent, for example. A core typically contains the components of the processor involved in executing instructions, such as an arithmetic logic unit (ALU), floating point unit (FPU), and/or various levels of cache (such as L1 and L2 cache), for example. A system agent may include various controllers such as serial or parallel data path controllers, various levels of cache (such as L3 cache) a snoop agent pipeline an on-die memory controller, and/or other logic.

Communication between the microprocessor 20 and the memory 40 may be facilitated by a memory controller (or chipset) 30, which may also facilitate in communicating with the peripheral components 50. The memory controller 30 may be on-die with a component such as a microprocessor 20, an offload engine 44, a memory of the memory 40, or a component of the peripheral components 50, for example, or may be separate.

Peripheral components 50 which are storage devices may be, for example, non-volatile storage, such as solid-state drives (SSD), magnetic disk drives including redundant arrays of independent disks (RAID), optical disk drives, a tape drive, flash memory, etc. The storage may comprise an internal storage device or an attached or network accessible storage. The microprocessor 20 is configured to write data in and read data from the memory 40. Programs in the storage are loaded into the memory and executed by the processor. The offload data transfer engine 44 facilitates memory to memory data transfers which bypass the microprocessor to lessen the load of such transfers on the microprocessor 20. As explained in greater detail below, one embodiment of a memory interface having selective noise tolerance modes of memory operation in accordance with the present description, can provide a suitable level of power reduction as appropriate for a particular application..

A network controller or adapter enables communication with a network, such as an Ethernet, a Fiber Channel Arbitrated Loop, etc. Further, the architecture may, in certain embodiments, include a video controller configured to display information represented by data in a memory on a display monitor, where the video controller may be embodied on a video card or integrated on integrated circuit components mounted on a motherboard or other substrate. An input device is used to provide user input to the processor, and may include a keyboard, mouse, pen-stylus, microphone, touch sensitive display screen, input pins, sockets, or any other activation or input mechanism known in the art. An output device is capable of rendering information transmitted from the processor, or other component, such as a display monitor, printer, storage, output pins, sockets, etc. The network adapter may embodied on a network card, such as a Peripheral Component Interconnect (PCI) card, PCI-express, or some other I/O card, or on integrated circuit components mounted on a motherboard or other substrate. The peripheral components 50 may also include RF receiver/transmitters such as in a mobile telephone embodiment, for example. Additional examples of peripheral components 50 which may be provided in the system include an audio device and temperature sensor to deliver temperature updates for storage in the memory.

One or more of the components of the system 10 may be omitted, depending upon the particular application. For example, a network router may lack a video controller, for example.

Any one or more of the devices of FIG. 1 including the cache 25, memory 40, system 10, memory controller 30 and peripheral components 50, may include a memory employing a memory interface having selective noise tolerance modes of memory operation in accordance with the present description, including random access memory such as DRAM or SRAM memory. The memory employing the memory interface may also be embodied as any type of data storage capable of storing data in a persistent manner (even if power is interrupted to the memory) such as but not limited to byte-addressable, write-in-place non-volatile memory, ferroelectric transistor random-access memory (FeTRAM), nanowire-based non-volatile memory, Magnetoresistive random-access memory (MRAM), Spin Transfer Torque (STT)-MRAM, Phase Change Memory (PCM), storage class memory (SCM), universal memory, Ge2Sb2Te5, programmable metallization cell (PMC), resistive memory (RRAM), RESET (amorphous) cell, SET (crystalline) cell, PCME, Ovshinsky memory, ferroelectric memory (also known as polymer memory and poly(N-vinylcarbazole)), ferromagnetic memory (also known as Spintronics, SPRAM (spin-transfer torque RAM)), STRAM (spin tunneling RAM), magnetic memory, magnetic random access memory (MRAM), and Semiconductor-oxide-nitride-oxide semiconductor (SONOS, also known as dielectric memory). Such types of memory in accordance with embodiments described herein can be used either in stand-alone memory circuits or logic arrays, or can be embedded in microprocessors and/or digital signal processors (DSPs). Additionally, it is noted that although systems and processes are described herein primarily with reference to types of memory for microprocessor based systems in the illustrative examples, it will be appreciated that in view of the disclosure herein, certain aspects, architectures, and principles of the disclosure are equally applicable to other types of memory for use in other types of logic devices.

One or more of the memory 40 and storage devices of the peripheral components 50 may have a rectangular or orthogonal array of rows and columns of cells such as bit cells in which each bit cell is configured to store a bit state. An array of bit cells may be logically subdivided in an array 52 of regions 54 (FIG. 2a). Depending upon the size of the memory, the array of bit cells may have tens, hundreds, thousands, or more of such regions 54. A region 54 may be logically subdivided in an array 60 of blocks 70 (FIG. 2b). Depending upon the size of the memory, the array of blocks may have tens, hundreds, thousands, or more of such blocks 70. In one embodiment, the memory 40 or storage device of the peripheral components 50 may include a non-volatile memory such as a flash memory, for example, in which each block 70 represents the smallest subunit of the memory which may be erased at one time.

Each block 70 may in turn be subdivided into an array of sectors 74 (FIG. 3a). Depending upon the size of the memory, a block 70 of sectors 74 may have a single sector or tens, hundreds, thousands, or more of such sectors 74. Each sector 74 may in turn be subdivided into an array of memory locations 80 (FIG. 3b). Depending upon the size of the memory, a sector 74 of memory locations 80 may have tens, hundreds, thousands, or more of such memory locations 80. One specific example of a sector is sized sufficiently to store 512 bytes of data. Each memory location includes one or more bit cells to store a bit, a byte, a word or other subunit of data, depending upon the particular application. Although a memory interface in accordance with the present description is described in connection with storing data in a block of one or more sectors, it is appreciated that other units of data storage such as pages, tracks, segments, files, volumes, disks, drives, etc., may be utilized, depending upon the particular application.

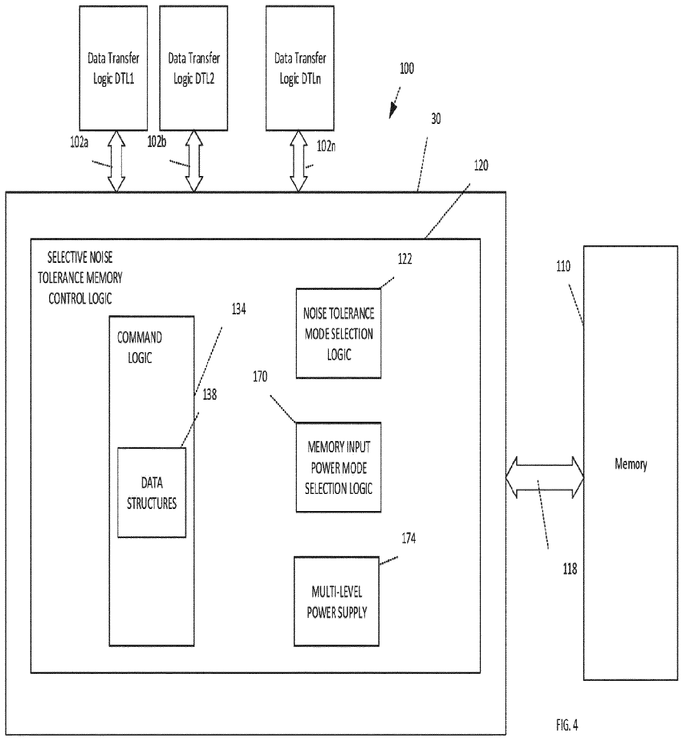

FIG. 4 is a high-level block diagram illustrating selected aspects of another embodiment of a computing system implementing a memory interface 100 in accordance with the present description. In this embodiment, the computing system includes a plurality of data transfer logic elements, DTL1, DTL2, ... DTLn (wherein n is any positive integer greater than 1), each of which may include a central processing unit, an offload data transfer engine, or other local or remote data transfer logic. Each data transfer logic such as the data transfer logic DTL1, for example, is configured to generate and transmit over an appropriate parallel or serial bus or other data path 102a, 102b, ... 102n, to a memory 110 of the interface 100, a memory transaction request such as a read command or a write command, and an address such as a system memory address at which the memory transaction is to take place.

The memory interface 100 provides an interface between the plurality of data transfer logic elements, DTL1, DTL2, ... DTLn, and of one or more volatile and memories. For example, volatile memory is a storage medium that requires power to maintain the state of data stored by the medium. Conversely, non-volatile memory is a storage medium that does not require power to maintain the state of data stored by the medium. However, both volatile and non-volatile memory often require input power to perform a memory transaction request such as a read command or a write command to read data from or write data to, respectively, the memory.

In the illustrated embodiment, the memory 110 may represent a SRAM type volatile memory. However, it is appreciated that selective noise tolerance modes of memory operation in accordance with the present description may be employed with a variety of host, storage and other memory devices such as for example, solid state memory devices that use chalcogenide phase change material (e.g., chalcogenide glass), three-dimensional (3D) crosspoint memory, or memory that incorporates memristor technology. It is appreciated that other types of memory may benefit from a memory interface having selective noise tolerance modes of memory operation in accordance with the present description, depending upon the particular application.

A memory controller 30 of the interface 100 is configured to control input and output operations to and from the memory 110 which includes an array of bitcells. Accordingly, the memory controller 30 is configured to perform in response to a memory transaction request and a system address from a data transfer logic elements, DTL1, DTL2, ... DTLn, a memory transaction such as a read operation or a write operation at a memory address of the memory 110 as a function of the received system address.

The memory controller 30 is coupled to the memory 110 by an appropriate parallel or serial bus or other data path 118. For example, the data path 118 may be a bus in which memory transaction requests, memory addresses, error messages, and other data are transmitted in accordance with a suitable transactional protocol. The path 118 may also include power output signals from the multi-level power supply 174. It is appreciated that the hardware aspects and transmission protocols of the data paths 102a, 102b, ... 102n, 118 may vary, depending upon the particular application.

The memory controller 30 includes a selective noise tolerance memory control logic 120 which is configured to provide selective memory modes of memory operation in accordance with the present description. Each memory mode operates a memory as represented by the memory 110 as a function of the level of noise tolerance for the data of a workload being processed by a data transfer logic element issuing memory transaction requests to the memory for purposes of reading and storing data in the memory. As the level of noise tolerance for the data of a workload being processed by a data transfer logic element changes, the memory mode of the memory 110 may be changed accordingly. Thus, in one embodiment, the selective noise tolerance memory control logic 120 includes noise tolerance mode selection logic 122 which is configured to select a particular noise tolerance mode for a memory as a function of the particular level of noise tolerance for the data of a workload being processed by a data transfer logic element issuing memory transaction requests to the memory for purposes of reading or storing data in the memory.

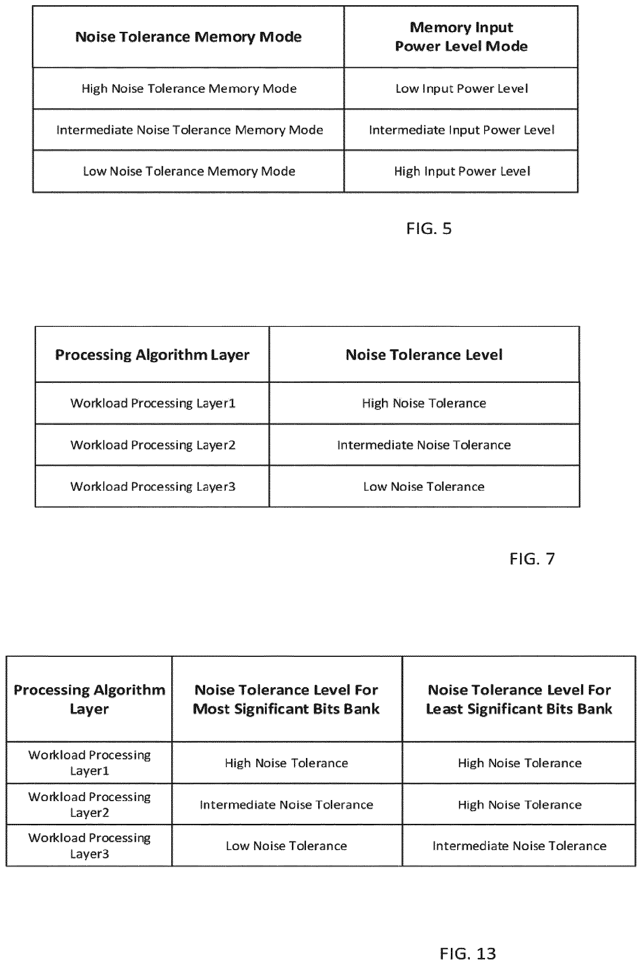

In one embodiment, the selective noise tolerance memory control logic 120 (FIG. 4) also includes command logic 134 configured to receive a command from a processor such as one of the data transfer logic DTL1, DTL2 ... DTLn. Accordingly, the noise tolerance mode selection logic 122 is further configured to select a memory mode in response to a command received by the command logic 134. In one embodiment, a command received by the command logic 134 may include a parameter which identifies a selected memory mode. FIG. 5 is a data structure represented as a chart depicting examples of various memory modes in accordance with the present description including a high noise tolerance memory mode, an intermediate noise tolerance memory mode and a low noise tolerance memory mode, for example. Although the chart of FIG. 5 depicts three examples of memory modes, it is appreciated that a system employing selective noise tolerance modes of memory operation in accordance with the present description, may employ fewer or more memory modes, depending upon the particular application.

Thus, the noise tolerance mode selection logic 122 may be configured to select a noise tolerance memory mode as identified by memory mode parameter accompanying a command received by the command logic 134. The memory mode parameter identifying the selected noise tolerance mode may be stored in a suitable data structure 138 of the command logic 134 in some embodiments.

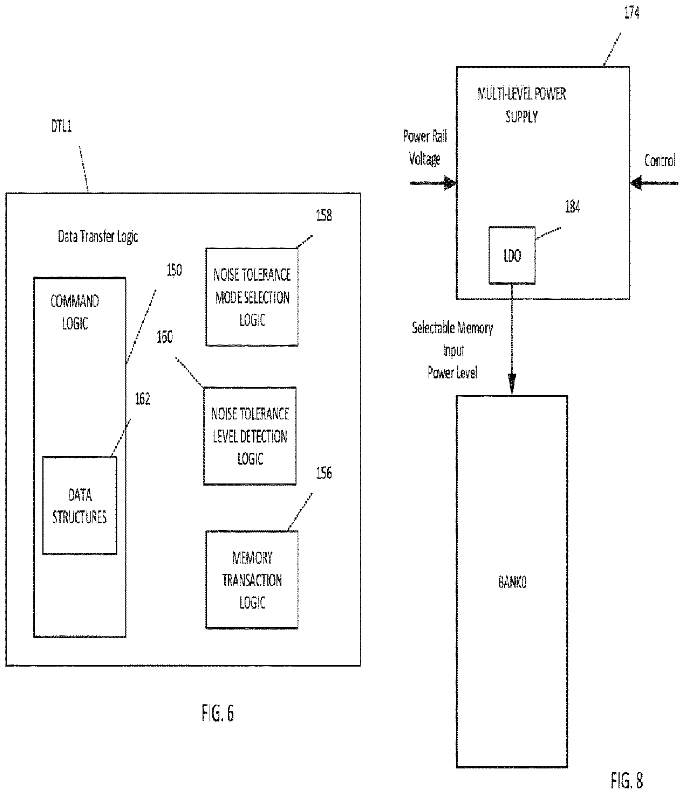

FIG. 6 shows one embodiment of a processor such as a data transfer logic DTL1, for example, which includes command logic 150 configured to issue to a memory controller such as the memory controller 30 (FIG. 4), a command which includes a memory mode parameter identifying a selected noise tolerance mode. The command logic 134 of the recipient memory controller 30 decodes the command and the noise tolerance mode selection logic 122 of the recipient memory controller 30 selects a noise tolerance mode for the memory controlled by the memory controller 30 in accordance with the memory mode parameter of the received and decoded command, identifying a selected noise tolerance mode.

The data transfer logic DTL1 in this embodiment further includes memory transaction logic 156 which is configured to issue read and write transactions to a memory. As explained in greater detail below, the memory of the memory controller receiving a memory mode identifying command, is operated in the selected noise tolerance mode, reading, writing or storing data of the workload being processed, in the selected noise tolerance mode in accordance with the level of noise tolerance for the data of the workload being processed.

In this embodiment, a noise tolerance mode for a memory storing data is selected by noise tolerance selection logic 158 (FIG. 6) of the data transfer logic DTL1, which is configured to select a noise tolerance mode as a function of the level of noise tolerance for the data of a workload being processed by a data transfer logic element such as a data transfer logic DTL1, for example. The level of noise tolerance for the data of a workload being processed may be detected by noise tolerance level detection logic 160. Thus, the noise tolerance mode selection logic 158 selects a noise tolerance mode as a function of the level of noise tolerance detected by the noise tolerance level detection logic 160, for the data of a workload being processed by a data transfer logic element such as a data transfer logic DTL1, for example.

For example, deep learning based algorithms are frequently employed in machine learning areas such as map recognition, audio/video recognition, video summarization etc. Processing of such algorithms is often performed in layers in which the output of one layer provides the input to a higher layer. FIG. 7 shows an example of a processing algorithm having three processing layers, workload processing layer1, workload processing layer2 and workload processing layer3. Algorithms can frequently tolerate a degree of "noise" in the data being processed. As previously mentioned, the term "noise" as used herein, "noise" refers to errors in the data being processed.

It is appreciated herein that deep learning based algorithms and other algorithms having multiple layers of processing often exhibit varying levels of noise immunity or noise tolerance from layer to layer. For example, the initial processing layers such as workload processing layer1 (FIG. 7), for example, tend to be more tolerant of noise in the data being processed, as compared to upper processing layers such as workload processing layer3, for example, which tend to be more abstract or complex. Accordingly, the more abstract or complex a processing layer, the less tolerant to noise in the data being processed by the particular layer.

For example, an algorithm may have an initial layer (such as workload processing layer1, for example) which processes map data representing a coast line of a land mass, for example. By interpolating two relatively close data points, an expected range of values for an intermediate data point may be calculated. If the intermediate data point is outside the expected range, the intermediate data point may be discarded as "noise" to improve the results of the initial layer of processing. In this manner, the initial layer has a relatively high degree of noise tolerance. In contrast, a higher processing level which processes land mass area data, for example, may have a lesser degree of tolerance for noise in the data being processed.

Thus, in one example, the noise tolerance level detection logic 160 (FIG. 6) may detect the level of noise tolerance of a workload being processed by identifying the particular layer of an algorithm being processed as the workload of a processor. If the layer being processed is detected by the noise tolerance level detection logic 160 (FIG. 6) as being an initial layer, such as workload processing layer1, for example, a noise tolerance level associated with that layer, such as a high noise tolerance, for example, may be identified by a programmable look up table or other data structure of the data structures 162, for example, as represented by the chart of FIG. 7. In response, the noise tolerance mode selection logic 158 selects a noise tolerance mode compatible with the identified level of noise tolerance, such as the high noise tolerance memory mode (FIG. 5), for example, and the command logic 150 issues a command to the memory controller 30 controlling the memory storing the data being processed by the detected layer to switch the noise tolerance mode of the memory to the selected noise tolerance mode as appropriate.

In the illustrated embodiment, a look-up table or other programmable data structure is described for use to correlate the various processing layers of an algorithm to associated levels of noise tolerance. It is appreciated that other techniques may be employed to identify a level of noise tolerance associated with a processing layer being performed. It is further appreciated that other techniques may be employed to select a particular noise tolerance mode for a memory as a function of the particular level of noise tolerance for the data of a workload being processed by a data transfer logic element issuing memory transaction requests to the memory for purposes of reading and storing data in the memory.

In the embodiment of FIG. 6, the command logic 150, noise tolerance mode selection logic 158 and the noise tolerance level detection logic 160 are implemented with suitable software, hardware or a combination thereof associated with a processor such as a data transfer logic DTL1, for example. It is appreciated that one or more of the software, hardware or other components of one or more of the command logic 150, noise tolerance mode selection logic 158 and the noise tolerance level detection logic 160 may be located in whole or in part in other elements of a computer employing selective noise tolerance modes of operation in accordance with the present description. For example, one or more of the software, hardware or other components of one or more of the command logic 150, noise tolerance mode selection logic 158 and the noise tolerance level detection logic 160 may be located in whole or in part in a memory controller 30 and its associated software such as a driver for the memory controller 30.

In another aspect of the present description, the input voltage to the memory is dynamically scaled based on the current workload's noise immunity or tolerance, that is, the noise tolerance or immunity for the data of the current layer being executed by a processor storing data in and reading data from the memory. In one embodiment, such dynamic scaling of the input power to the memory can dynamically reduce the power consumed by the memory and well as reduce active leakage.

In the embodiment of FIG. 4, the selective noise tolerance memory control logic 120 of the memory controller 30 includes memory input power mode selection logic 170 configured to select an input power level mode in which each input power level mode has an associated programmable input power level (FIG. 5) provided by a multi-level power supply 174. As noted above, the noise tolerance level detection logic 160 (FIG. 6) of a data processor currently executing a layer of a workload detects the level of noise tolerance of the workload layer being processed. In response, the noise tolerance mode selection logic 158 selects a noise tolerance mode compatible with the identified level of noise tolerance, and the command logic 150 issues a command to the memory controller 30 controlling the memory storing the data being processed by the detected layer to switch the noise tolerance mode of the memory to the selected noise tolerance mode as appropriate.

Thus, the noise tolerance mode selection logic 122 (FIG. 4) of the memory controller receiving the command, selects a memory mode in response to the command received by the command logic 134 as a function of the detected level of noise tolerance of the workload layer being processed. In response to the memory mode selected by the noise tolerance mode selection logic 122, the memory input power mode selection logic 170 selects an input power mode having an associated level of input power to the memory. As shown in FIG. 8, the multi-level power supply 174 includes a regulator 184, such as a low-dropout (LDO) regulator, for example, which may be a direct current (DC) linear voltage regulator. The LDO regulator receives power at a power rail input and ouputs power (designated "selectable memory input power level" in the embodiment of FIG. 8) at a selectable, programmable power level to a memory bank, bank0 in this example, of a multi-bank memory 110 (FIG. 4), as a function of a control signal ("control") provided by the memory input power mode selection logic 170. In this manner, a computer system in accordance with one aspect of the present description has logic configured to select a level of input power to the memory as a function of noise tolerance level of a workload being processed.

As previously mentioned FIG. 5 is a data structure represented as a chart depicting examples of various noise tolerance memory modes in accordance with the present description including a high noise tolerance memory mode, an intermediate noise tolerance memory mode and a low noise tolerance memory mode, for example. As shown in the example of FIG. 5, each noise tolerance memory mode has an associated input power level. In this example, the greater the degree of noise tolerance for the data of the workload, the more the input power to the memory may be reduced to reduce power consumption. It is appreciated that in other embodiments, the relationship between noise tolerance and input power to the memory may vary, depending upon the particular application.

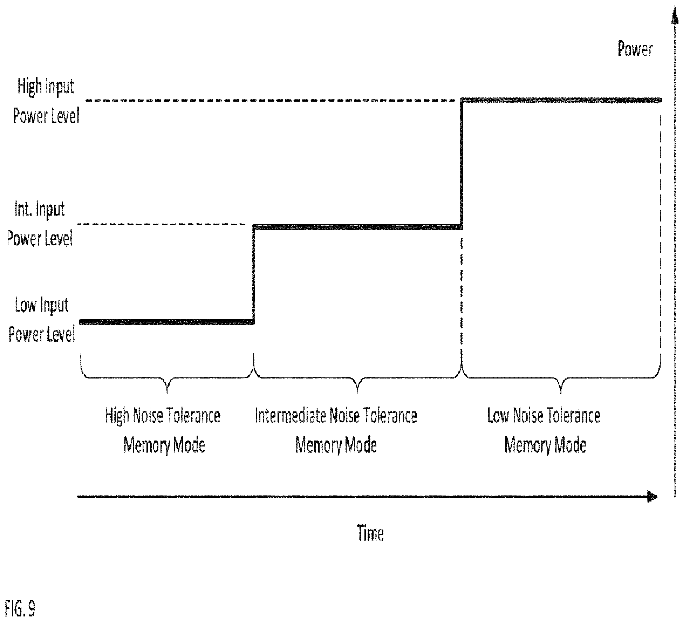

FIG. 9 depicts an example of the level of input power to a memory such as the bank0 of FIG. 8, for example, being dynamically changed as the noise tolerance for the data stored in the bank0 of the workload being processed changes. Thus, in this example, if the noise tolerance for the data stored in the bank0 of the workload being processed (such as workload processing layer1 of FIG. 7, for example) is initially at a high level of tolerance, a high noise tolerance memory mode may be selected having an associated low input power level to the bank0 as shown in FIGs. 5 and 9. If the processing layer changes such that the noise tolerance for the data stored in the bank0 of the workload being processed changes from a high level of tolerance to an intermediate level of tolerance (such as the intermediate noise tolerance level of the workload processing layer2 of FIG. 7, for example), an intermediate noise tolerance memory mode may be selected having an associated intermediate input power level to the bank0 (FIG. 8) as shown in FIGs. 5 and 9. Thus, the input power to the bank0 (FIG. 8) may be dynamically raised from the low input power level of the high noise tolerance memory mode, to the intermediate input power level of the intermediate noise tolerance memory mode. Similarly, if the processing layer changes again such that the noise tolerance for the data stored in the bank0 (FIG. 8) of the workload being processed changes from an intermediate level of tolerance to a low level of tolerance (such as the low noise tolerance level of the workload processing layer3 of FIG. 7, for example), a low noise tolerance memory mode may be selected having an associated high input power level to the bank0 as shown in FIGs. 5 and 9. Thus, the input power to the bank0 (FIG. 8) may be dynamically raised from the intermediate input power level of the intermediate noise tolerance memory mode, to the high input power level of the low noise tolerance memory mode.

In this manner, an input voltage to a memory bank or array of memory banks may be dynamically trimmed based upon the noise tolerance level for the data of the current workload being processed. As a result, power consumption may be reduced as well as active leakage. Further, in mobile applications, battery life may be increased.

It is appreciated that reduction of memory input power may introduce some bit errors into the data of the current workload. However, in many applications, it is not expected that these errors would significantly affect the program outcome, particularly in applications having a high or relatively high tolerance for noise in the data. For example, input data representing feature maps typically has a strong level of spatial correlation which lends itself to a relatively high level of noise tolerance.

As the overall algorithm being processed advances into subsequent layers which may have a lower tolerance for noise in the data or may otherwise require a higher memory input power level, the memory input power may be trimmed up to levels required for those workloads. It is believed that, depending upon the application, a 10% reduction in the memory input power level can save on the order of 20% reduction in dynamic power and leakage, at the expense of tolerable memory errors. Moreover, selective memory input power techniques in accordance with the present description may be transparent to the algorithm processing software and need not rely upon data format conversions, depending upon the particular application.

For purposes of providing an example, FIG. 9 depicts a particular sequence of memory modes and associated memory input power levels. However, it is appreciated that changes in noise tolerance memory modes and associated memory input power levels may occur dynamically in a variety of different sequences, depending upon the particular application. Thus, memory input power levels may be changed dynamically from high levels to low levels and vice versa, either directly or through intermediate power levels, for example.

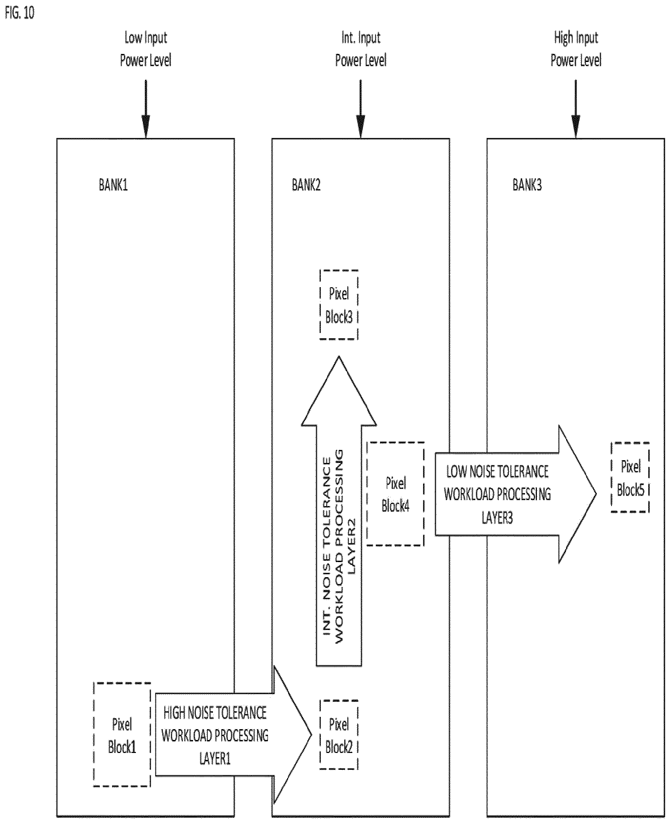

FIG. 10 depicts a multi-bank embodiment of a memory of a computer system employing selective memory input power in accordance with one aspect of the present description. In this embodiment, the memory 110 (FIG. 4) includes three banks of memory, bank1, bank2 and bank3, each bank storing data for a workload layer having an associated tolerance level for noise in the data stored in the bank. Accordingly, the level of memory input power provided to each bank, bank1, bank2 and bank3, is a function of the associated tolerance level for noise in the data stored in the bank for the associated workload layer.

Thus, in this example, the data read from and stored in the bank1 is processed by a workload processing layer such as workload processing layer1 of FIG. 7, for example. As such the noise tolerance for the data stored in the bank0 of the workload processing layer1 being processed is determined to be at a high level of noise tolerance as indicated in FIG. 7. In this example, input data for the workload processing layer1 is pixel data as represented by a block of pixel data indicated "Pixel Block1" in FIG. 10. Further, the pixel data stored in the memory bank1 has a strong spatial correlation which lends itself to a relatively high level of noise tolerance. Thus, the input pixel data may represent a map feature, for example, or video data of a video file, for example. Accordingly, a high noise tolerance memory mode may be selected for memory bank1 in which the selected memory mode has an associated low input power level (indicated as "Low Input Power Level") to the bank1 as shown in FIGs. 5 and 10.

The input data stored in the memory bank1 is processed by the workload processing layer1 as represented in FIG. 10 by an arrow labeled "high noise tolerance workload processing layer1" and is output and stored in a memory bank2 as output data represented by a block of pixel data indicated "Pixel Block2" in FIG. 10. The output pixel data processed by the workload processing layer1 and stored in the memory bank2 has a somewhat weaker spatial correlation which lends itself to an intermediate level of noise tolerance. Accordingly, an intermediate noise tolerance memory mode may be selected for memory bank1 in which the selected memory mode has an associated intermediate input power level (indicated as "Int. Input Power Level") to the memory bank2 as shown in FIGs. 5 and 10.

Data stored in the memory bank2 as represented by the Pixel Block2, is processed by the workload processing layer2 as represented in FIG. 10 by an arrow labeled "intermediate noise tolerance workload processing layer2" and is output and stored in the memory bank2 as output data represented by a block of pixel data indicated "Pixel Block3" in FIG. 10. The pixel data of Pixel Block3, like the pixel data of Pixel Block2, has a somewhat weaker spatial correlation as compared to the pixel data of Pixel Block 1 stored in memory bank1, and as such also lends itself to an intermediate level of noise tolerance. Accordingly, the previously selected intermediate noise tolerance memory mode for memory bank2 is appropriate. As noted above, the selected intermediate noise tolerance memory mode has an associated intermediate input power level (indicated as "Int. Input Power Level") to the memory bank2 as shown in FIGs. 5 and 10.

Data stored in the memory bank2 as represented by a Pixel Block4 for a workload processing layer3, is processed by the workload processing layer3 as represented in FIG. 10 by an arrow labeled "low noise tolerance workload processing layer3" and is output and stored in the memory bank3 as output data represented by a block of pixel data indicated "Pixel Block5" in FIG. 10. The output pixel data processed by the workload processing layer3 and stored in the memory bank3 has a still weaker spatial correlation as compared to the pixel data of Pixel Block2, Block3 and Block4 stored in the memory bank2, and as such also lends itself to a low level of noise tolerance. Accordingly, a low noise tolerance memory mode for memory bank3 may be selected having an associated high input power level (indicated as "High Input Power Level") to the memory bank3 as shown in FIGs. 5 and 10.

In one embodiment, the levels of noise tolerance for the data stored in the memory banks, bank1, bank2 and bank3 may be relatively constant such that the memory input power levels, low input power level, intermediate input power level and high input power level provided to the memory banks, bank1, bank2 and bank3, respectively, may remain relatively constant as well. In other embodiments, if the noise tolerance level for one or more banks changes, the memory input power level to a bank may be dynamically changed as a function of the changing levels of noise tolerance for the data stored in the particular banks.

For purposes of providing an example, FIG. 10 depicts a particular arrangement of memory modes and associated memory input power levels for an array of memory banks. However, it is appreciated that noise tolerance memory modes and associated memory input power levels may be arranged in a variety of different levels and sequences, depending upon the particular application.

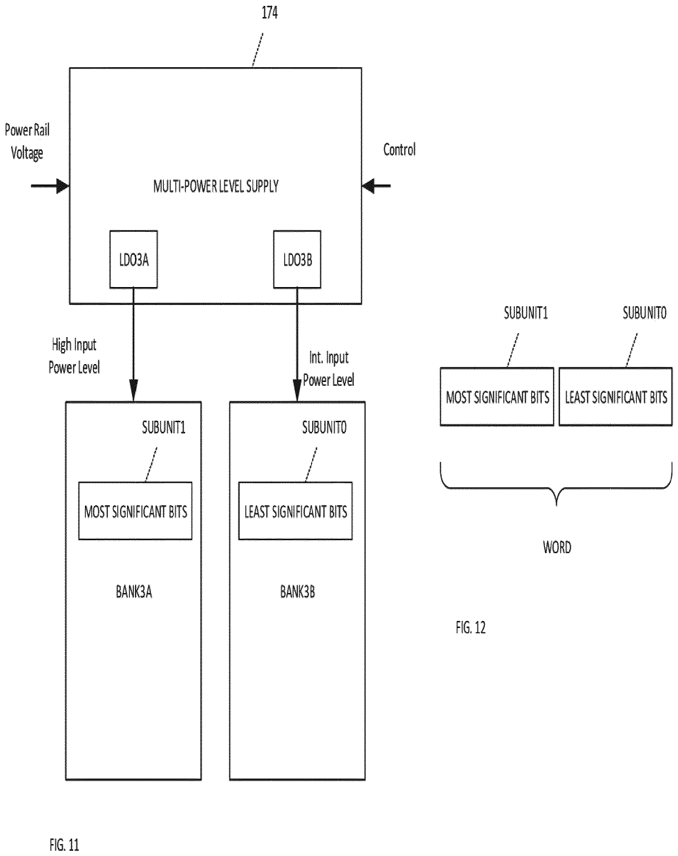

FIG. 11 depicts another multi-bank embodiment of a memory of a computer system employing selective memory input power in accordance with one aspect of the present description. In this embodiment, the memory 110 (FIG. 4) includes two banks of memory, bank3A, and bank3B, each bank storing a portion of a data word for a workload layer having an associated tolerance level for noise in the data stored in the bank. FIG. 12 shows an example of a data word having a first portion (designated subunit1) which includes the most significant bits of the of the word in this example, and a second portion (designated subunit0) which includes the least significant bits of the word in this example. The subunit1 of most significant bits of the word is stored in memory bank3A and the subunit0 of least significant bits of the word is stored in memory bank3B.

The level of memory input power provided to each bank, bank3A, bank3B, is a function of the associated tolerance level for noise in the data stored in the bank3A, and bank3B of a workload layer being processed such as the workload processing layer3 of FIG. 10. Accordingly, in one embodiment, the bank3 of FIG. 10 may be implemented in the embodiment of FIG. 11 as two banks, bank3A for subunit1 of most significant bits of a data word for a workload processing layer3 having a low associated tolerance level for noise in the data stored in the memory. In addition, the level of memory input power provided to each bank, bank3A, bank3B, is also a function of the significance of the bits of the word portions stored in the banks, bank3A and bank3B, respectively.

Thus, in this example, the data read from and stored in the bank3A and bank3B is processed by a workload processing layer such as workload processing layer3 of FIGs. 7, 10 for example. As such the noise tolerance for the data stored in the memory of the workload processing layer3 being processed is determined to be at a low level of noise tolerance as indicated in FIG. 7. Accordingly, a low noise tolerance memory mode for memory bank3A may be selected having an associated high input power level (indicated as "High Input Power Level" from a voltage regulator LDO3A) to the memory bank3A as shown in FIGs. 11 and 13, because the memory bank3A contains the most significant bits of the data word being stored for the workload processing layer3. Because the memory bank3B stores the least significant bits of the data word being stored for the workload processing layer3, a more noise tolerant memory mode may be selected for memory bank3B as indicated by the intermediate input power level input (Int. Input Power Level" from a voltage regulator LDO3B) to the memory bank3B as shown in FIGs. 11 and 13. Accordingly, it is appreciated that reduction of memory input power to the memory bank3B as compared to the memory input power level for the memory bank3A may introduce some bit errors into the data of the current workload which is stored in the memory bank3B. However, in many applications, it is not expected that these errors would significantly affect the program outcome, particularly in applications having a high or relatively high tolerance for noise in the least significant bits of the data.

In a similar manner, the memory bank2 storing data for the workload processing layer2 of FIG. 10 may be split into two or more banks for most significant bits and least significant bits of a word of data stored for the workload processing layer2 of FIG. 10. As indicated in the data structure represented as a chart of FIG. 13, the memory bank storing the most significant bits of a word of data may be operated in an intermediate noise tolerance memory mode as described above in connection with FIG. 10, and a memory bank storing the least significant bits of a word of data for the workload processing layer2 may be operated in a memory mode having a greater degree of noise tolerance such as a high noise tolerance, for example, as indicated in the chart of FIG. 13.

In the example of FIG. 13, the memory portions storing the most significant bits and the least significant bits of a word for the workload processing layer1 have a common noise tolerance level selected, that is, the high noise tolerance level, for example. In such instances, a single memory bank for storing the data word may be utilized, depending upon the particular application.

In the embodiment of FIG. 11, the multi-level power supply 174 includes a plural regulators as represented by the LDO regulators LDO3A, LDO3B, to provide multiple selectable input power levels to the various memory banks in response to appropriate control signals from the memory input power mode selection logic 170 (FIG. 4). In this manner, a computer system in accordance with one aspect of the present description has logic configured to select a plurality of levels of input power to one or more memory devices as a function of noise tolerance level or levels of a workload or workloads being processed.

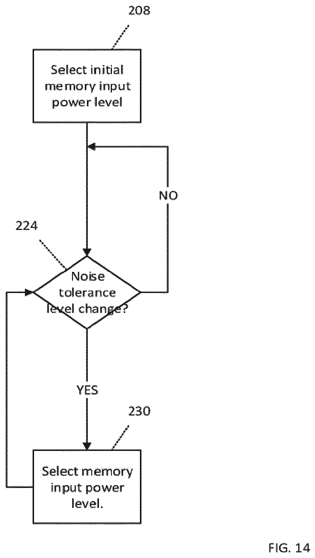

FIG. 14 depicts one embodiment of operations of a computer system employing selective memory input power as a function of noise tolerance levels, in accordance with the present description. In one operation, an initial memory input power level is selected (block 208). Thus, as shown above in connection with FIG. 10, for example, a low input power level, an intermediate power level and a high input power level may be selected for memory bank1, bank2 and bank3, respectively. Such initial memory input power levels may be selected as default values, for example, or may be selected as a function of initially detected noise tolerance levels for data stored in the memory banks in connection with workload processing layers being executed or to be executed.

For example, as described above in connection with the embodiment of FIG. 4, memory input power mode selection logic 170 selects an input power level mode in which each an input power level mode has an associated input power level provided by the multi-level power supply 174 as depicted in the example of FIG. 5. In one example, the noise tolerance level detection logic 160 (FIG. 6) of a data processor currently executing a layer of a workload detects the level of noise tolerance of the workload layer being processed. In response, the noise tolerance mode selection logic 158 selects a noise tolerance mode compatible with the identified level of noise tolerance, and the command logic 150 issues a command to the memory controller 30 controlling the memory storing the data being processed by the detected layer to switch the noise tolerance mode of the memory to the selected noise tolerance mode as appropriate.

Thus, the noise tolerance mode selection logic 122 (FIG. 4) of the memory controller receiving the command, selects a memory mode in response to the command received by the command logic 134 as a function of the detected level of noise tolerance of the workload layer being processed. In response to the memory mode selected by the noise tolerance mode selection logic 122, the memory input power mode selection logic 170 selects an input power mode having an associated level of input power to the memory. The multi-level power supply ouputs power (designated "selectable memory input power level" in the embodiment of FIG. 8) at a selectable power level to a memory bank, such as bank1, for example, as a function of a control signal ("control") provided by the memory input power mode selection logic 170. In this manner, a computer system in accordance with one aspect of the present description may select a level of input power to the memory as a function of noise tolerance level of a workload being processed.

As shown in the example of FIG. 5, each noise tolerance memory mode has an associated input power level. In this example, the greater the degree of noise tolerance for the data of the workload, the more the input power to the memory may be reduced to reduce power consumption.

A determination is made (block 224, FIG. 14) as to whether the noise tolerance level for the data of a workload processing layer has changed. If so, an appropriate memory input power level is selected (block 230).

As previously mentioned, FIG. 9 depicts an example of the level of input power to a memory such as the bank1 of FIG. 10, being dynamically changed as the noise tolerance for the data stored in the bank1 of the workload being processed changes. Thus, in this example, if the noise tolerance for the data stored in the bank1 of the workload being processed (such as workload processing layer1 of FIG. 7, for example) is initially at a high level of tolerance, a high noise tolerance memory mode may be selected having an associated low input power level to the bank1 as shown in FIGs. 5, 9 and 10. If the noise tolerance for the data stored in the bank1 of the workload being processed changes from a high level of tolerance to an intermediate level of tolerance (such as the intermediate noise tolerance level of the workload processing layer2 of FIG. 7, for example), an intermediate noise tolerance memory mode may be selected having an associated intermediate input power level to the bank1 (FIG. 10) as shown in FIGs. 5 and 9. Thus, the input power to the bank1 (FIG. 10) may be dynamically raised from the low input power level of the high noise tolerance memory mode, to the intermediate input power level of the intermediate noise tolerance memory mode. Similarly, if the noise tolerance for the data stored in the bank1 (FIG. 10) of the workload being processed changes from an intermediate level of tolerance to a low level of tolerance (such as the low noise tolerance level of the workload processing layer3 of FIG. 7, for example), a low noise tolerance memory mode may be selected having an associated high input power level to the bank1 as shown in FIGs. 5 and 9. Thus, the input power to the bank1 (FIG. 10) may be dynamically raised from the intermediate input power level of the intermediate noise tolerance memory mode, to the high input power level of the low noise tolerance memory mode.

In this manner, an input voltage to a memory bank or array of memory banks may be dynamically trimmed based upon the noise tolerance level for the data of the current workload being processed. As a result, power consumption may be reduced as well as active leakage. Further, in mobile applications, battery life may be increased.

It is appreciated that reduction if memory input power may introduce some bit errors into the data of the current workload. However, as set forth above, in many applications, it is not expected that these errors would significantly affect the program outcome, particularly in applications having a high or relatively high tolerance for noise in the data. For example, input data representing feature maps typically has a strong spatial correlation which lends itself to a relatively high level of noise tolerance.

It is demonstrated above that as the overall algorithm being processed advances into subsequent layers which may have a lower tolerance for noise in the data or may otherwise require a higher memory input power level, the memory input power may be trimmed up to levels required for those workloads. Moreover, selective memory input power techniques in accordance with the present description may be transparent to the algorithm processing software and need not rely upon data format conversions, depending upon the particular application.

It is appreciated that the operations depicted in the figures may be performed by memory interface logic having selective noise tolerance modes of memory operation utilizing architectures other than that depicted in the figures and employing other types of logic components. The logic components discussed herein including the logic elements depicted in figures may be configured to perform the described operations using appropriate hardware, software or firmware, or various combinations thereof. The software may be in the form of firmware, programs, drivers and other instruction sets, and the hardware may be in the form of general purpose logic devices such as microprocessors or specific purpose logic devices such as a memory controller, DMA controller or engine or ASIC device, for example.

The hardware, software or firmware for devices employing selective noise tolerance modes of memory operation in accordance with the present description, may be physically or logically located in any component of the system including memory itself, a controller such as a memory controller, DMA controller, a microprocessor, etc. Thus, in one embodiment, one or more of the memory interface logic elements depicted in the figures, may be implemented with one or more of hardware of a memory controller, firmware for a memory controller, and software such as associated driver software of a memory controller. In another embodiment, one or more of the memory interface logic elements depicted in the figures may be implemented with one or more of controller hardware such as the central processing unit, for example, or other controller, firmware for the controller hardware and software for the controller hardware such as programs and drivers executed by the controller hardware such as a central processing unit for example. In another embodiment, one or more of the memory interface logic elements depicted in the figures may be implemented with hardware, firmware or software for both an offload data transfer engine and a central processing unit, for example.

It is appreciated that a devices employing selective noise tolerance modes of memory operation in accordance with the present description can, depending upon the particular application, can reduce power consumption. Other aspects may be achieved, depending upon the particular application.

In certain applications, a device in accordance with the present description, may be embodied in a computer system including a video controller to render information to display on a monitor or other display coupled to the computer system, a device driver and a network controller, such as a computer system comprising a desktop, workstation, server, mainframe, laptop, handheld computer, etc. Alternatively, the device embodiments may be embodied in a computing device that does not include, for example, a video controller, such as a switch, router, etc., or does not include a network controller, for example.

The illustrated logic of figures may show certain events occurring in a certain order. In alternative embodiments, certain operations may be performed in a different order, modified or removed. Moreover, operations may be added to the above described logic and still conform to the described embodiments. Further, operations described herein may occur sequentially or certain operations may be processed in parallel. Yet further, operations may be performed by a single processing unit or by distributed processing units.

## Claims

1. An apparatus for use with a memory (40, 110), comprising:
a memory controller (30) having input power mode selection logic (170) configured to select a level of input power to the memory as a function of noise tolerance level of a workload wherein the workload includes a first workload having a first level of noise tolerance and a second workload having a second level of noise tolerance, wherein the second level of noise tolerance of the second workload is lower than that of the first level of noise tolerance of the first workload, and wherein a level of the power input to the memory associated with second workload is higher than a level of the power input to the memory associated with the first workload
the memory controller further having a multi-level power supply (174) configured to provide the selected level of power to the memory,
wherein the first workload is a first layer of a deep learning neural network and the second workload is a second, subsequent layer of the deep learning neural network.

2. The apparatus of claim 1 wherein the input power mode selection logic is configured to dynamically raise power input to the memory as a function of a change in workload from the first workload having the first level of noise tolerance, to the second workload having the second level of noise tolerance lower than the first level of noise tolerance.

3. The apparatus of any claim of claims 1-2, wherein the first layer of a deep learning neural network is configured to process data having a first level of spatial correlation and the second layer of the deep learning neural network is configured to process data having a second level of spatial correlation weaker than that of data of the first level of spatial correlation.

4. The apparatus of any claim of claims 1-3 wherein the memory includes a first bank and a second bank, and wherein the memory controller is configured to store a unit of data having first and second subunits of bits of data in the memory, including storing the first subunit of bits in the first bank of the memory, and storing the second subunit of bits in the second bank of the memory wherein bits of the first subunit are more significant than bits of the second subunit.

5. The apparatus of claim 4 wherein the multi-level power supply of the memory controller is configured to provide input power at selected levels to the first and second banks of the memory wherein the input power mode selection logic is configured to select a level of input power to the first bank of the memory at a higher power level than a selected level of input power to the second bank of the memory.

6. The apparatus of claim 5 wherein the memory controller is further configured to dynamically raise power input to at least one of the first and second banks of the memory as a function of a change in a workload from the first workload having the first level of noise tolerance, to the second workload having the second level of noise tolerance lower than the first level of noise tolerance.

7. The apparatus of any claim of claims 1-6 further comprising a system, said system comprising a processor (20), a memory (40, 110), said memory controller (30) and at least one of:
a display communicatively coupled to the processor, a network interface communicatively coupled to the central processing unit, and a battery coupled to provide power to the system.

8. A method, comprising:
inputting power to a memory (40, 110) at a first power level;
using a processor (20) and the memory, processing a first workload having a first level of noise tolerance;
using the processor and the memory, processing a second workload having a second level of noise tolerance different from the first level of noise tolerance; and
inputting power to the memory at a second power level different from the first power level, as a function of noise tolerance level of a workload being processed; and
wherein the second level of noise tolerance of the second workload is lower than that of the first level of noise tolerance of the first workload, and wherein the second power level of the power input to the memory as the second workload is being processed is higher than the first power level of the power input to the memory as the first workload is being processed;
wherein the first workload is a first layer of a deep learning neural network and the second workload is a second, subsequent layer of the deep learning neural network; and
wherein the first layer of a deep learning neural network processes data having a first level of spatial correlation and the second layer of the deep learning neural network processes data having a second level of spatial correlation weaker than that of data of the first level of spatial correlation.

9. The method of claim 8 further including dynamically raising power input to the memory from the first power level to the second level as a function of changing a workload being processed by the processor and memory from the first workload having the first level of noise tolerance, to the second workload having the second level of noise tolerance lower than the first level of noise tolerance.

10. The method of any claims of claims 8-9 further comprising storing a unit of data in the memory, wherein the storing include storing a first subunit of bits in a first bank of the memory, and storing a second subunit of bits in a second bank of the memory wherein bits of the first subunit are more significant than bits of the second subunit; and inputting power to the first and second banks of the memory wherein power is input to the first bank of the memory at a higher power level than the power input the second bank of the memory.

11. The method of claim 10 further including dynamically raising power input to at least one of the first and second banks of the memory as a function of changing a workload being processed by the processor and memory from the first workload having the first level of noise tolerance, to the second workload having the second level of noise tolerance lower than the first level of noise tolerance.

12. A computer readable medium having stored thereon computer executable instructions to cause a computer system to perform the method of any of claims 8-11.

## Patentansprüche

1. Vorrichtung zur Verwendung mit einem Speicher (40, 110), die Folgendes umfasst:
eine Speichersteuerung (30), die eine Eingangsleistungsbetriebsart-Auswahllogik (170) aufweist, die konfiguriert ist, einen Pegel einer Eingangsleistung für den Speicher in Abhängigkeit von einem Rauschtoleranzpegel einer Arbeitslast auszuwählen, wobei die Arbeitslast eine erste Arbeitslast, die einen ersten Rauschtoleranzpegel aufweist, und eine zweite Arbeitslast, die einen zweiten Rauschtoleranzpegel aufweist, umfasst, wobei der zweite Rauschtoleranzpegel der zweiten Arbeitslast niedriger als der erste Rauschtoleranzpegel der ersten Arbeitslast ist und wobei ein Pegel der dem Speicher zugeführten Leistung, der der zweiten Arbeitslast zugeordnet ist, höher ist als ein Pegel der dem Speicher zugeführten Leistung, der der ersten Arbeitslast zugeordnet ist,
wobei die Speichersteuerung ferner eine mehrstufige Leistungsquelle (174) aufweist, die so konfiguriert ist, dass sie den ausgewählten Pegel der Leistung für den Speicher bereitstellt,
wobei die erste Arbeitslast eine erste Schicht eines neuronalen Netzes zum maschinellen Lernen ist und die zweite Arbeitslast eine zweite, nachfolgende Schicht des neuronalen Netzes zum maschinellen Lernen ist.

2. Vorrichtung nach Anspruch 1, wobei die Eingangsleistungsbetriebsart-Auswahllogik so konfiguriert ist, dass sie eine Leistung, die dem Speicher zugeführt wird, in Abhängigkeit von einer Änderung der Arbeitslast von der ersten Arbeitslast, die den ersten Rauschtoleranzpegel aufweist, zu der zweiten Arbeitslast, die den zweiten Rauschtoleranzpegel aufweist, der niedriger als der erste Rauschtoleranzpegel ist, dynamisch erhöht.

3. Vorrichtung nach einem der Ansprüche 1-2, wobei die erste Schicht eines neuronalen Netzes zum maschinellen Lernen konfiguriert ist, Daten zu verarbeiten, die einen ersten Grad einer räumlichen Korrelation aufweisen, und wobei die zweite Schicht des neuronalen Netzes zum maschinellen Lernen konfiguriert ist, Daten zu verarbeiten, die einen zweiten Grad einer räumlichen Korrelation aufweisen, der schwächer als der von Daten des ersten Grads einer räumlichen Korrelation ist.

4. Vorrichtung nach einem der Ansprüche 1-3, wobei der Speicher eine erste Speicherbank und eine zweite Speicherbank umfasst und wobei die Speichersteuerung konfiguriert ist, eine Dateneinheit zu speichern, die eine erste und eine zweite Untereinheit von Datenbits in dem Speicher aufweist, wobei das Speichern das Speichern der ersten Untereinheit von Bits in der ersten Speicherbank des Speichers und das Speichern der zweiten Untereinheit von Bits in der zweiten Speicherbank des Speichers umfasst, wobei Bits der ersten Untereinheit signifikanter als Bits der zweiten Untereinheit sind.

5. Vorrichtung nach Anspruch 4, wobei die mehrstufige Leistungsquelle der Speichersteuerung so konfiguriert ist, dass sie eine Eingangsleistung mit ausgewählten Pegeln für die erste und die zweite Speicherbank des Speichers bereitstellt, wobei die Eingangsleistungsbetriebsart-Auswahllogik so konfiguriert ist, dass sie einen Pegel einer Eingangsleistung für die erste Speicherbank des Speichers so wählt, dass sie auf einem höheren Leistungspegel als ein ausgewählter Pegel einer Eingangsleistung der zweiten Speicherbank des Speichers liegt.

6. Vorrichtung nach Anspruch 5, wobei die Speichersteuerung ferner so konfiguriert ist, dass sie Leistung, die der ersten und/oder der zweiten Speicherbank des Speichers zugeführt wird, in Abhängigkeit von einer Änderung einer Arbeitslast von der ersten Arbeitslast, die den ersten Rauschtoleranzpegel aufweist, zu der zweiten Arbeitslast, die den zweiten Rauschtoleranzpegel aufweist, der niedriger als der erste Rauschtoleranzpegel ist, dynamisch erhöht.

7. Vorrichtung nach einem der Ansprüche 1-6, die ferner ein System umfasst, wobei das System einen Prozessor (20), einen Speicher (40, 110), die Speichersteuerung (30) und wenigstens eines der folgenden Elemente umfasst:
eine Anzeige, die mit dem Prozessor kommunikationstechnisch gekoppelt ist, eine Netzschnittstelle, die mit der zentralen Verarbeitungseinheit kommunikationstechnisch gekoppelt ist, und eine Batterie, die so angeschlossen ist, dass sie das System mit Leistung versorgt.

8. Verfahren, das die folgenden Schritte umfasst:
Zuführen von Leistung zu einem Speicher (40, 110) mit einem ersten Leistungspegel;
Verwenden eines Prozessors (20) und des Speichers, Verarbeiten einer ersten Arbeitslast, die einen ersten Rauschtoleranzpegel aufweist;
Verwenden des Prozessors und des Speichers, Verarbeiten einer zweiten Arbeitslast, die einen zweiten Rauschtoleranzpegel aufweist, der sich von dem ersten Rauschtoleranzpegel unterscheidet; und
Zuführen von Leistung zu dem Speicher mit einem zweiten Leistungspegel, der sich von dem ersten Leistungspegel unterscheidet, in Abhängigkeit von einem Rauschtoleranzpegel einer zu verarbeitenden Arbeitslast;
wobei der zweite Rauschtoleranzpegel der zweiten Arbeitslast niedriger als der erste Rauschtoleranzpegel der ersten Arbeitslast ist und wobei der zweite Leistungspegel der Leistung, die dem Speicher zugeführt wird, wenn die zweite Arbeitslast verarbeitet wird, höher als der erste Leistungspegel der dem Speicher zugeführten Leistung ist, wenn die erste Arbeitslast verarbeitet wird;
wobei die erste Arbeitslast eine erste Schicht eines neuronalen Netzes zum maschinellen Lernen ist und die zweite Arbeitslast eine zweite, nachfolgende Schicht des neuronalen Netzes zum maschinellen Lernen ist; und
wobei die erste Schicht eines neuronalen Netzes zum maschinellen Lernen Daten verarbeitet, die einen ersten Grad einer räumlichen Korrelation aufweisen, und die zweite Schicht des neuronalen Netzes zum maschinellen Lernen Daten verarbeitet, die einen zweiten Grad einer räumlichen Korrelation aufweisen, der schwächer als jener von Daten des ersten Grads der räumlichen Korrelation ist.

9. Verfahren nach Anspruch 8, das ferner das Anheben einer Leistung, die dem Speicher zugeführt wird, von dem ersten Leistungspegel auf den zweiten Leistungspegel in Abhängigkeit von einer Änderung einer Arbeitslast, die durch den Prozessor und den Speicher verarbeitet wird, von der ersten Arbeitslast, die den ersten Rauschtoleranzpegel aufweist, zu der zweiten Arbeitslast, die den zweiten Rauschtoleranzpegel aufweist, der niedriger als der erste Rauschtoleranzpegel ist, umfasst.

10. Verfahren nach einem der Ansprüche 8-9, das ferner das Speichern einer Dateneinheit in dem Speicher umfasst, wobei das Speichern das Speichern einer ersten Untereinheit von Bits in einer ersten Speicherbank des Speichers und das Speichern einer zweiten Untereinheit von Bits in einer zweiten Speicherbank des Speichers, wobei Bits der ersten Untereinheit signifikanter als Bits der zweiten Untereinheit sind; und das Zuführen von Leistung zu der ersten und der zweiten Speicherbank des Speichers umfasst, wobei Leistung der ersten Speicherbank des Speichers auf einem höheren Leistungspegel als die Leistung, die der zweiten Speicherbank des Speichers zugeführt wird, zugeführt wird.

11. Verfahren nach Anspruch 10, das ferner ein dynamisches Anheben einer Leistung, die der ersten und/oder zweiten Speicherbank des Speichers zugeführt wird, in Abhängigkeit von einer Änderung einer Arbeitslast, die durch den Prozessor und den Speicher verarbeitet wird, von der ersten Arbeitslast, die den ersten Rauschtoleranzpegel aufweist, zu der zweiten Arbeitslast, die den zweiten Rauschtoleranzpegel aufweist, der niedriger als der erste Rauschtoleranzpegel ist, umfasst.

12. Computerlesbares Medium, auf dem Anweisungen gespeichert sind, die durch einen Computer ausführbar sind, um zu bewirken, dass ein Computersystem das Verfahren nach einem der Ansprüche 8-11 durchführt.

## Revendications

1. Appareil destiné à être utilisé avec une mémoire (40, 110), comprenant :
un contrôleur de mémoire (30) ayant une logique de sélection de mode de puissance d'entrée (170) configurée pour sélectionner un niveau de puissance d'entrée dans la mémoire en fonction du niveau de tolérance au bruit d'une charge de travail, où la charge de travail comprend une première charge de travail ayant un premier niveau de tolérance au bruit et une seconde charge de travail ayant un second niveau de tolérance au bruit, où le second niveau de tolérance au bruit de la seconde charge de travail est inférieur à celui du premier niveau de tolérance au bruit de la première charge de travail, et où un niveau de puissance appliquée en entrée à la mémoire associée à la seconde charge de travail est supérieur au niveau de la puissance appliquée en entrée à la mémoire associée à la première charge de travail,
le contrôleur de mémoire ayant en outre une alimentation de puissance à plusieurs niveaux (174) configurée pour fournir le niveau sélectionné de puissance à la mémoire,
où la première charge de travail est une première couche d'un réseau de neurones à apprentissage profond et la seconde charge de travail est une seconde couche subséquente du réseau de neurones à apprentissage profond.

2. Appareil selon la revendication 1, dans lequel la logique de sélection du mode de puissance d'entrée est configurée pour augmenter dynamiquement la puissance délivrée en entrée à la mémoire en fonction d'un changement de charge de travail de la première charge de travail ayant le premier niveau de tolérance au bruit à la seconde charge de travail ayant le second niveau de tolérance au bruit, inférieur au premier niveau de tolérance au bruit.

3. Appareil selon l'une quelconque des revendications 1 et 2, dans lequel la première couche d'un réseau de neurones à apprentissage profond est configurée pour traiter des données ayant un premier niveau de corrélation spatiale et la seconde couche du réseau de neurones à apprentissage profond est configurée pour traiter des données ayant un second niveau de corrélation spatiale plus faible que celui des données du premier niveau de corrélation spatiale.

4. Appareil selon l'une quelconque des revendications 1 à 3, dans lequel la mémoire comprend une première banque et une seconde banque, et où le contrôleur de mémoire est configuré pour stocker une unité de données ayant des première et seconde sous-unités de bits de données dans la mémoire, incluant le stockage de la première sous-unité de bits dans la première banque de la mémoire, et le stockage de la seconde sous-unité de bits dans la seconde banque de la mémoire, où les bits de la première sous-unité sont plus significatifs que des bits de la seconde sous-unité.

5. Appareil selon la revendication 4, dans lequel l'alimentation en puissance à plusieurs niveaux du contrôleur de mémoire est configurée pour délivrer une puissance d'entrée à des niveaux sélectionnés aux première et seconde banques de la mémoire, où la logique de sélection du mode de puissance d'entrée est configurée pour sélectionner un niveau de puissance d'entrée vers la première banque de la mémoire à un niveau de puissance plus élevé qu'un niveau sélectionné de puissance d'entrée vers la seconde banque de la mémoire.

6. Appareil selon la revendication 5, dans lequel le contrôleur de mémoire est en outre configuré pour augmenter dynamiquement la puissance d'entrée délivrée à au moins l'une des première et seconde banques de la mémoire en fonction d'un changement de charge de travail de la première charge de travail ayant le premier niveau de tolérance au bruit à la seconde charge de travail ayant le second niveau de tolérance au bruit, inférieur au premier niveau de tolérance au bruit.

7. Appareil selon l'une quelconque des revendications 1 à 6, comprenant en outre un système, ledit système comprenant un processeur (20), une mémoire (40, 110), ledit contrôleur de mémoire (30) et au moins un élément parmi les suivants :
un écran couplé de manière communicative au processeur, une interface réseau couplée de manière communicative à l'unité centrale de traitement et une batterie couplée pour délivrer de la puissance au système.

8. Procédé, comprenant les étapes suivantes :
délivrer en entrée de la puissance à une mémoire (40, 110) à un premier niveau de puissance ;
au moyen d'un processeur (20) et de la mémoire, traiter une première charge de travail ayant un premier niveau de tolérance au bruit ;
au moyen du processeur et de la mémoire, traiter une seconde charge de travail ayant un second niveau de tolérance au bruit, différent du premier niveau de tolérance au bruit ; et
délivrer en entrée de puissance à la mémoire à un second niveau de puissance différent du premier niveau de puissance, en fonction du niveau de tolérance au bruit d'une charge de travail en cours de traitement ; et
où le second niveau de tolérance au bruit de la seconde charge de travail est inférieur à celui du premier niveau de tolérance au bruit de la première charge de travail, et où le second niveau de puissance de la puissance délivrée en entrée à la mémoire pendant le traitement de la seconde charge de travail est supérieur au premier niveau de puissance de la puissance délivrée en entrée à la mémoire pendant le traitement de la première charge de travail ;
où la première charge de travail est une première couche d'un réseau de neurones à apprentissage profond et la seconde charge de travail est une seconde couche subséquente du réseau de neurones à apprentissage profond ; et
où la première couche d'un réseau de neurones à apprentissage profond traite des données ayant un premier niveau de corrélation spatiale et la seconde couche du réseau de neurones à apprentissage profond traite des données ayant un second niveau de corrélation spatiale plus faible que celui des données du premier niveau de corrélation spatiale.

9. Procédé selon la revendication 8, comprenant en outre d'augmenter dynamiquement la puissance délivrée en entrée à la mémoire du premier niveau de puissance au second niveau en fonction d'un changement de charge de travail traitée par le processeur et la mémoire de la première charge de travail ayant le premier niveau de tolérance au bruit à la seconde charge de travail ayant le second niveau de tolérance au bruit, inférieur au premier niveau de tolérance au bruit.

10. Procédé selon l'une quelconque des revendications 8 et 9, comprenant en outre de stocker une unité de données dans la mémoire, où le stockage comprend de stocker une première sous-unité de bits dans une première banque de la mémoire, et de stocker une seconde sous-unité de bits dans une seconde banque de la mémoire, où les bits de la première sous-unité sont plus significatifs que les bits de la seconde sous-unité ; et de délivrer en entrée de la puissance aux première et seconde banques de la mémoire, où la puissance est délivrée en entrée à la première banque de la mémoire à un niveau de puissance plus élevé que la puissance délivrée en entrée à la seconde banque de la mémoire.

11. Procédé selon la revendication 10, comprenant en outre d'augmenter dynamiquement la puissance délivrée en entrée à au moins l'une des première et seconde banques de la mémoire en fonction du changement de la charge de travail traitée par le processeur et la mémoire de la première charge de travail ayant le premier niveau de tolérance au bruit à la seconde charge de travail ayant le second niveau de tolérance au bruit, inférieur au premier niveau de tolérance au bruit.

12. Support lisible par ordinateur sur lequel sont stockées des instructions exécutables par ordinateur pour amener un système informatique à exécuter le procédé de l'une quelconque des revendications 8 à 11.
